# EUROPEAN PATENT APPLICATION

(11) **EP 3 879 557 A1**
(43) Date of publication of application: **15.09.2021**
(21) Application number: 20161844.4
(22) Date of filing: 09.03.2020
(51) Int. Cl.: H01J 37/04, H01J 37/09

(54) **APERTURE BODY, FLOOD COLUMN AND CHARGED PARTICLE TOOL**

(71) Applicant: ASML Netherlands B.V., 5500 AH Veldhoven (NL)
(72) Inventor: VAN SOEST, Jurgen, 5500 AH Veldhoven (NL); VAN DER KROON, Boudewijn, Weijert, Herman, Jan, 5500 AH Veldhoven (NL)
(74) Representative: ASML Netherlands B.V.

(57) **Abstract**

An aperture body for passing a portion of a charged particle beam propagating along a beam path comprising an axis, the aperture body comprising: an aperture portion defining an opening around the axis; wherein the aperture portion comprises, adjacent to the opening, an up-beam facing surface, and a down-beam facing surface; wherein the up-beam facing surface is angled with respect to a plane that is perpendicular to the axis, so that the opening in the up-beam facing surface is up-beam of a more radially outward portion of the up-beam facing surface.

## Description

### FIELD

The present invention relates to an aperture body, a flood column comprising the aperture body, and a charged particle tool comprising the flood column.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an import process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause electrons to be emitted from the surface, such as secondary electrons, backscattered electrons or Auger electrons. The generated secondary electrons may be emitted from the material structure of the sample. By scanning the primary electron beam as the probing spot over the sample surface, secondary electrons can be emitted across the surface of the sample. By collecting these emitted secondary electrons from the sample surface, a pattern inspection tool may obtain an image representing characteristics of the material structure of the surface of the sample.

Dedicated flood columns may be used in conjunction with an SEM to flood a large area of the surface of a substrate or other sample with charged particles in a relatively short time. Flood columns are thus useful tools to pre-charge a wafer surface and set the charging conditions for subsequent inspection with an SEM. A dedicated flood column can enhance the voltage contrast defect signal, thereby increasing the defect detection sensitivity and/or throughput of an SEM. During charged particle flooding, the flood column is used to provide a relatively large amount of charged particles to quickly charge a predefined area. Afterwards, the primary electron source of an e-beam inspection system is applied to scan an area within the pre-charged area to achieve imaging of the area.

### SUMMARY

Embodiments of the invention are directed to an aperture body, such as an aperture body for use in a flood column.

According to the present invention, there is provided an aperture body for passing a portion of a charged particle beam propagating along a beam path comprising an axis, the aperture body comprising: an aperture portion defining an opening around the axis; wherein the aperture portion comprises, adjacent to the opening, an up-beam facing surface, and a down-beam facing surface; wherein the up-beam facing surface is angled with respect to a plane that is perpendicular to the axis, so that the opening in the up-beam facing surface is up-beam of a more radially outward portion of the up-beam facing surface.

According to the present invention, there is also provided a combination of a blanking electrode and the aperture body, wherein the blanking electrode is positioned in the up-beam direction relative to the aperture body, and wherein the blanking electrode is configured to selectively deflect the charged particle beam onto the up-beam facing surface of the aperture body so as to prevent any portion of the charged particle beam from passing through the opening.

According to the present invention, there is also provided a flood column for charged particle flooding of a sample, the flood column comprising the aperture body or the combination.

According to the present invention, there is also provided a flood column for charged particle flooding of a sample, the flood column comprising: an aperture body comprising an aperture portion defining an opening for the passage of at least a portion of the charged particle beam; an interface for physically connecting the flood column to a primary column of a charged particle tool; and a thermal conditioning channel that is integrated in the aperture body, wherein the thermal conditioning channel is configured to provide a thermal conditioning fluid to the interface before circulating the thermal conditioning fluid around the aperture portion.

According to the present invention, there is also provided a charged particle tool comprising: the flood column for charged particle flooding of the sample; and a charged particle inspection tool comprising: a primary column for directing a primary charged particle beam onto the surface of the sample; and a detection column for detecting charged particles emitted from the surface of the sample due to the primary charged particle beam.

According to the present invention, there is also provided an aperture body for passing a portion of a charged particle beam along a beam path, the aperture body comprising: an aperture portion having an up-beam facing surface and a down-beam facing surface, an opening around the beam path defined in and common to the up-beam and down-beam facing surfaces, wherein the up-beam facing surface is angled a) with respect to the beam path, so that the up-beam facing surface allows charged particles travelling along the beam path to be deflected radially outwardly; or b) so that the opening in the up-beam facing surface is up-beam of a more radially outward portion of the up-beam facing surface.

According to the present invention, there is also provided an aperture body for passing a portion of a charged particle beam along a beam path, the aperture body comprising: an aperture portion having an up-beam facing surface and a down-beam facing surface, an opening around the beam path defined in and common to the up-beam and down-beam facing surfaces, wherein the up-beam and down-beam facing surfaces are respectively angled so that a dimension of the aperture portion between the up-beam and down-beam facing surfaces is smallest in the direction of the beam path at the opening.

Advantages of the present invention will become apparent from the following description taken in conjunction with the accompanying drawings wherein are set forth, by way of illustration and example, certain embodiments of the present invention.

### BRIEF DESCRIPTION OF FIGURES

The above and other aspects of the present disclosure will become more apparent from the description of exemplary embodiments, taken in conjunction with the accompanying drawings, in which:
**FIG. 1** schematically depicts a charged particle beam inspection apparatus;
**FIG. 2** schematically depicts a charged particle tool, which may form part of the charged particle beam inspection apparatus of **FIG. 1****;**
**FIG. 3** schematically depicts an embodiment of an aperture body, which may form part of a flood column of the charged particle tool of **FIG. 2****;** and
**FIG. 4a** and **FIG. 4b** schematically depict an embodiment of a combination of an aperture body and a blanking electrode, which may form part of a flood column of the charged particle tool of **FIG. 2****.**

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. Just one "killer defect" can cause device failure. The goal of the manufacturing process is to improve the overall yield of the process. For example, to obtain a 75% yield for a 50-step process (where a step can indicate the number of layers formed on a wafer), each individual step must have a yield greater than 99.4%. If an individual step has a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially if operator intervention is required for reviewing the defects. Thus, high throughput detection and identification of micro and nano-scale defects by inspection tools (such as a Scanning Electron Microscope ('SEM')) is essential for maintaining high yield and low cost.

A SEM comprises a scanning device and a detector apparatus. The scanning device comprises an illumination system that comprises an electron source, for generating primary electrons, and a projection system for scanning a sample, such as a substrate, with one or more focused beams of primary electrons. The primary electrons interact with the sample and generate secondary electrons. A detection system captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

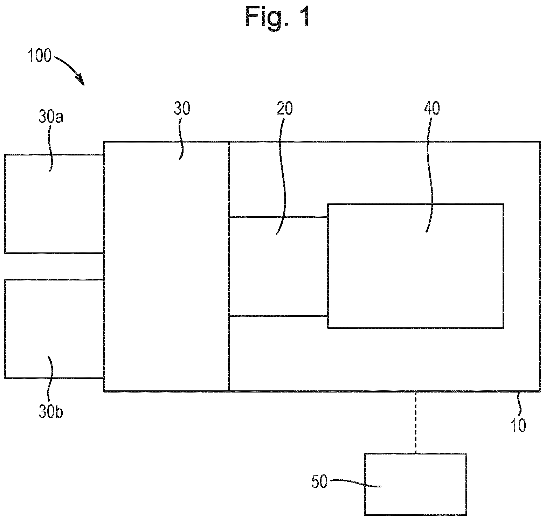

Reference is now made to Fig. 1, which is a schematic diagram illustrating a charged particle beam inspection apparatus 100. The charged particle beam inspection apparatus 100 of Fig. 1 includes a main chamber 10, a load lock chamber 20, a charged particle tool 40, an equipment front end module (EFEM) 30 and a controller 50. Charged particle tool 40 is located within main chamber 10. Charged particle tool 40 may be an electron beam tool 40. Charged particle tool 40 may be a single-beam tool or a multi-beam tool.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam tool by which it may be subject to charged particle flooding and/or inspection.

Controller 50 is electronically connected to charged particle beam tool 40. Controller 50 may be a processor (such as a computer) configured to control the charged particle beam inspection apparatus 100. Controller 50 may also include a processing circuitry configured to execute various signal and image processing functions. While controller 50 is shown in Fig. 1 as being outside of the structure that includes main chamber 10, load lock chamber 20, and EFEM 30, it is appreciated that controller 50 may be part of the structure. The controller 50 may be located in one of the component elements of the charged particle beam inspection apparatus 100 or it can be distributed over at least two of the component elements.

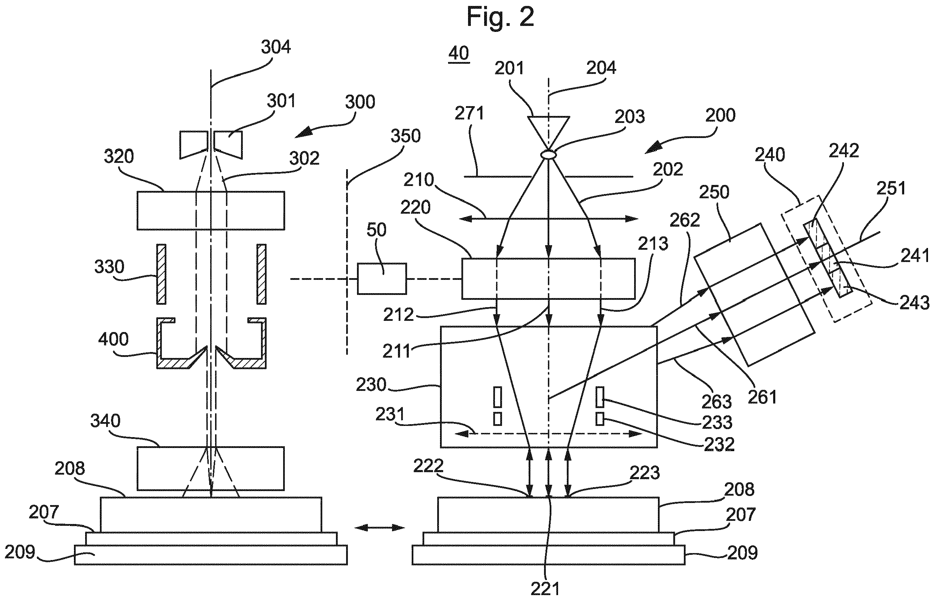

Reference is now made to FIG. 2, which is a schematic diagram illustrating an exemplary charged particle tool 40. The charged particle tool 40 may form part of the charged particle beam inspection apparatus 100 of Fig. 1. The charged particle tool 40 may comprise a charged particle inspection tool 200. As shown in Fig. 1, the charged particle inspection tool 200 may be a multi-beam inspection tool 200. Alternatively, the charged particle inspection tool 200 may be a single-beam inspection tool. The charged particle inspection tool 200 comprises an electron source 201, a gun aperture plate 271, a condenser lens 210, optionally a source conversion unit 220, a primary projection system 230, a motorized stage 209, and a sample holder 207. The electron source 201, the gun aperture plate 271, the condenser lens 210, and optionally the source conversion unit 220 are the components of an illumination system comprised by the charged particle inspection tool 200. The sample holder 207 is supported by motorized stage 209 so as to hold and optionally to position a sample 208 (e.g., a substrate or a mask), for example for inspection or for charged particle flooding. The charged particle inspection tool 200 may further comprise a secondary projection system 250 and an associated electron detection device 240 (which together may form a detection column or detection system). Electron detection device 240 may comprise a plurality of detection elements 241, 242, and 243. Primary projection system 230 may comprise an objective lens 231 and optionally the source conversion unit 220 (if it is not part of the illumination system). Together the primary projection system and the illumination system may be referred to as a primary column or primary electron-optical system. A beam separator 233 and a deflection scanning unit 232 may be positioned inside primary projection system 230.

The components that are used to generate a primary beam may be aligned with a primary electron-optical axis of the charged particle inspection tool 200. These components can include: the electron source 201, gun aperture plate 271, condenser lens 210, source conversion unit 220, beam separator 233, deflection scanning unit 232, and primary projection apparatus 230. Secondary projection system 250 and its associated electron detection device 240 may be aligned with a secondary electron-optical axis 251 of the charged particle inspection tool 200.

The primary electron-optical axis 204 is comprised by the electron-optical axis of the part of the charged particle inspection tool 200 that is the illumination system. The secondary electron-optical axis 251 is the electron-optical axis of the part of the charged particle inspection tool 200 that is a detection system (or detection column). The primary electron-optical axis 204 may also be referred to herein as the primary optical axis (to aid ease of reference) or charged particle optical axis. The secondary electron-optical axis 251 may also be referred to herein as the secondary optical axis or the secondary charged particle optical axis.

Electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form a primary electron beam 202 that forms a primary beam crossover (virtual or real) 203. Primary electron beam 202 may be visualized as being emitted from primary beam crossover 203.

In this arrangement a primary electron beam, by the time it reaches the sample, and preferably before it reaches the projection system, is a multi-beam. Such a multi-beam can be generated from the primary electron beam in a number of different ways. For example, the multi-beam may be generated by a multi-beam array located before the cross-over, a multi-beam array located in the source conversion unit 220, or a multi-beam array located at any point in between these locations. A multi-beam array may comprise a plurality of electron beam manipulating elements arranged in an array across the beam path. Each manipulating element may influence the primary electron beam to generate a sub-beam. Thus the multi-beam array interacts with an incident primary beam path to generate a multi-beam path down-beam of the multi-beam array.

Gun aperture plate 271, in operation, is configured to block off peripheral electrons of primary electron beam 202 to reduce Coulomb effect. The Coulomb effect may enlarge the size of each of probe spots 221, 222, and 223 of primary sub-beams 211, 212, 213, and therefore deteriorate inspection resolution. A gun aperture plate 271 may also be referred to as a coulomb aperture array.

Condenser lens 210 is configured to focus primary electron beam 202. Condenser lens 210 may be designed to focus primary electron beam 202 to become a parallel beam and be normally incident onto source conversion unit 220. Condenser lens 210 may be a movable condenser lens that may be configured so that the position of its first principle plane is movable. The movable condenser lens may be configured to be magnetic. Condenser lens 210 may be an anti-rotation condenser lens and/or it may be movable.

Source conversion unit 220 may comprise an image-forming element array, an aberration compensator array, a beam-limit aperture array, and a pre-bending micro-deflector array. The pre-bending micro-deflector array may deflect a plurality of primary sub-beams 211, 212, 213 of primary electron beam 202 to normally enter the beam-limit aperture array, the image-forming element array, and an aberration compensator array. In this arrangement, the image-forming element array may function as a multi-beam array to generate the plurality of sub-beams in the multi-beam path, i.e. primary sub-beams 211, 212, 213. The image forming array may comprise a plurality electron beam manipulators such as micro-deflectors micro-lenses (or a combination of both) to influence the plurality of primary sub-beams 211, 212, 213 of primary electron beam 202 and to form a plurality of parallel images (virtual or real) of primary beam crossover 203, one for each of the primary sub-beams 211, 212, and 213. The aberration compensator array may comprise a field curvature compensator array (not shown) and an astigmatism compensator array (not shown). The field curvature compensator array may comprise a plurality of micro-lenses to compensate field curvature aberrations of the primary sub-beams 211, 212, and 213. The astigmatism compensator array may comprise a plurality of micro-stigmators, or multi-pole electrodes, to compensate astigmatism aberrations of the primary sub-beams 211, 212, and 213. The beam-limit aperture array may be configured to limit diameters of individual primary sub-beams 211, 212, and 213. FIG. 2 shows three primary sub-beams 211, 212, and 213 as an example, and it should be understood that source conversion unit 220 may be configured to form any number of primary sub-beams. Controller 50 may be connected to various parts of charged particle beam inspection apparatus 100 of FIG. 1, such as source conversion unit 220, electron detection device 240, primary projection system 230, or motorized stage 209. As explained in further detail below, controller 50 may perform various image and signal processing functions. Controller 50 may also generate various control signals to govern operations of the charged particle beam inspection apparatus, including the charged particle multi-beam apparatus.

Condenser lens 210 may further be configured to adjust electric currents of primary sub-beams 211, 212, 213 down-beam of source conversion unit 220 by varying the focusing power of condenser lens 210. Alternatively, or additionally, the electric currents of the primary sub-beams 211, 212, 213 may be changed by altering the radial sizes of beam-limit apertures within the beam-limit aperture array corresponding to the individual primary sub-beams. The electric currents may be changed by both altering the radial sizes of beam-limit apertures and the focusing power of condenser lens 210. If the condenser lens is moveable and magnetic, off-axis sub-beams 212 and 213 may result that illuminate source conversion unit 220 with rotation angles. The rotation angles change with the focusing power or the position of the first principal plane of the movable condenser lens. A condenser lens 210 that is an anti-rotation condenser lens may be configured to keep the rotation angles unchanged while the focusing power of condenser lens 210 is changed. Such a condenser lens 210 that is also movable, may cause the rotation angles not change when the focusing power of the condenser lens 210 and the position of its first principal plane are varied.

Objective lens 231 may be configured to focus sub-beams 211, 212, and 213 onto a sample 208 for inspection and may form three probe spots 221, 222, and 223 on the surface of sample 208.

Beam separator 233 may be, for example, a Wien filter comprising an electrostatic deflector generating an electrostatic dipole field and a magnetic dipole field (not shown in FIG. 2). In operation, beam separator 233 may be configured to exert an electrostatic force by electrostatic dipole field on individual electrons of primary sub-beams 211, 212, and 213. The electrostatic force is equal in magnitude but opposite in direction to the magnetic force exerted by magnetic dipole field of beam separator 233 on the individual electrons. Primary sub-beams 211, 212, and 213 may therefore pass at least substantially straight through beam separator 233 with at least substantially zero deflection angles.

Deflection scanning unit 232, in operation, is configured to deflect primary sub-beams 211, 212, and 213 to scan probe spots 221, 222, and 223 across individual scanning areas in a section of the surface of sample 208. In response to incidence of primary sub-beams 211, 212, and 213 or probe spots 221, 222, and 223 on sample 208, electrons are generated from the sample 208 which include secondary electrons and backscattered electrons. The secondary electrons propagate in three secondary electron beams 261, 262, and 263. The secondary electron beams 261, 262, and 263 typically have secondary electrons (having electron energy < 50eV) and may also have at least some of the backscattered electrons (having electron energy between 50eV and the landing energy of primary sub-beams 211, 212, and 213). The beam separator 233 is arranged to deflect the path of the secondary electron beams 261, 262, and 263 towards the secondary projection system 250. The secondary projection system 250 subsequently focuses the path of secondary electron beams 261, 262, and 263 onto a plurality of detection regions 241, 242, and 243 of electron detection device 240. The detection regions may be the separate detection elements 241, 242, and 243 that are arranged to detect corresponding secondary electron beams 261, 262, and 263. The detection regions generate corresponding signals which are sent to controller 50 or a signal processing system (not shown), e.g. to construct images of the corresponding scanned areas of sample 208.

The detection elements 241, 242, and 243 may detect the corresponding secondary electron beams 261, 262, and 263. On incidence of secondary electron beams with the detection elements 241, 242 and 243, the elements may generate corresponding intensity signal outputs (not shown). The outputs may be directed to an image processing system (e.g., controller 50). Each detection element 241, 242, and 243 may comprise one or more pixels. The intensity signal output of a detection element may be a sum of signals generated by all the pixels within the detection element.

The controller 50 may comprise image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to an electron detection device 240 of the apparatus 40 permitting signal communication, such as an electrical conductor, optical fiber cable, portable storage media, IR, Bluetooth, internet, wireless network, wireless radio, among others, or a combination thereof. The image acquirer may receive a signal from electron detection device 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample based on an imaging signal received from the electron detection device 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. The electron distribution data, collected during a detection time window, can be used in combination with corresponding scan path data of each of primary sub-beams 211, 212, and 213 incident on the sample surface, to reconstruct images of the sample structures under inspection. The reconstructed images can be used to reveal various features of the internal or external structures of sample 208. The reconstructed images can thereby be used to reveal any defects that may exist in the sample.

The controller 50 may control motorized stage 209 to move sample 208 during inspection of sample 208. The controller 50 may enable motorized stage 209 to move sample 208 in a direction, preferably continuously, for example at a constant speed, at least during sample inspection. The controller 50 may control movement of the motorized stage 209 so that it changes the speed of the movement of the sample 208 dependent on various parameters. For example, the controller may control the stage speed (including its direction) depending on the characteristics of the inspection steps of scanning process.

Although **FIG.** 2 shows that the charged particle inspection tool 200 uses three primary electron sub-beams, it is appreciated that the charged particle inspection tool 200 may use two or a greater number of primary electron sub-beams. The present disclosure does not limit the number of primary electron beams used in the charged particle inspection tool 200. The charged particle inspection tool 200 may also be a single-beam inspection tool 200, which uses a single charged particle beam.

As shown in Fig. 2, the charged particle beam tool 40 may further comprise a flood column 300. The flood column 300 may be used to pre-charge the surface of the sample 208 and set the charging conditions. For example the flood column may pre-charge the surface of the sample 208 prior to inspection by the charged particle inspection apparatus 200. This may enhance the voltage contrast defect signal, so as to increase the defect detection sensitivity and/or throughput of the charged particle inspection apparatus 200. The flood column 300 may be used to provide a relatively large amount of charged particles to charge a predefined area. Afterwards, the charged particle inspection apparatus 200 may scan the pre-charged area of the sample 208 to achieve imaging of the area. The motorized stage 209 may move the sample 208 from a position for charged particle flooding by the flood column 300 to a position for inspection by the charged particle inspection apparatus 200. Put another way, the motorized stage 209 may be used to move the sample 208 into the position for charged particle flooding, then the flood column 300 may flood the sample 208 with charged particles, then the motorized stage 209 may be used to move the sample 208 into the position for inspection, and then the charged particle inspection apparatus 200 may be used to inspect the sample 208. Alternatively, the position for charged particle flooding by the flood column 300 may coincide with the position for inspection by the charged particle inspection apparatus 200, such that the sample 208 and the motorized stage 209 remain substantially in place after charged particle flooding and before inspection.

The flood column 300 may comprise a charged particle source 301 which may be in a generator system, a condenser lens 320, a blanker electrode 330, an objective lens 340 and an aperture body 400. The flood column 300 may also comprise additional components for manipulation of the charged particle beam 302 such as a scanning element (not shown) and a field lens (not shown). The components of the flood column 300 may be arranged substantially along an axis 304. The axis 304 may be the electro-optical axis of the flood column 300. The components of the flood column 300 may be controlled by the controller 50. Alternatively, a dedicated controller may be used to control the components of the flood column 300, or the components of the flood column 300 may be controlled by multiple respective controllers. The flood column 300 may be mechanically coupled to the charged particle inspection apparatus 200, in particular to the primary column of the charged particle inspection apparatus 200, at an interface 350 between the flood column 300 and the primary column.

The charged particle source 301 may be an electron source. The charged particle source 301 may comprise a charged particle emitting electrode (e.g. a cathode) and an accelerating electrode (e.g. an anode). The charged particles are extracted or accelerated from the charged particle emitting electrode by the accelerating electrode to form a charged particle beam 302. The charged particle beam 302 may propagate along a beam path 302. The beam path 302 may comprise the axis 304, for example in situations in which the charged particle beam 302 is not deflected away from the axis 304.

The condenser lens 320 is positioned down-beam of the charged particle source 301, i.e. the condenser lens 320 is positioned in a down-beam direction relative to the charged particle source 301. The condenser lens 320 may focus or defocus the charged particle beam 302. As shown in Fig. 2, the condenser lens 320 may be used to collimate the charged particle beam 302. However, the condenser lens 320 may also be used to control the charged particle beam 302 so as to create a divergent beam or a convergent beam.

The aperture body 400 may be positioned down-beam of the condenser lens 320. The aperture body 400 may pass a portion, or only a portion and not all, of a charged particle beam propagating along an axis 304. The aperture body 400 may limit the lateral extent of the charged particle beam 302, as depicted in Fig. 2. The aperture body 400 may also be used to selectively blank the charged particle beam 302, so as to prevent passage of any portion of the charged particle beam 302. The aperture body 400 may define an opening. If the lateral extent (or diameter) of the charged particle beam 302 is larger than the lateral extent (or diameter) of the opening, then only a portion of the charged particle beam 302 will pass through the opening. The aperture body 400 may thus limit the lateral extent of the charged particle beam 302, so as to act as a beam-limiting aperture. The cross section of the beam down-beam of the aperture body 400 may be geometrically similar (in case of a divergent or convergent beam) or geometrically identical (in case of a collimated beam) to the cross-section of the opening in the aperture body 400.

The blanking electrode 330 may be positioned down-beam of the condenser lens 320 and up-beam of the aperture body 400. The blanking electrode 330 may selectively deflect the charged particle beam 302, for example deflect the charged particle beam 302 away from the axis 304. The blanking electrode 330 may deflect the charged particle beam 302 away from the opening in the aperture body 400, for example onto a portion of the aperture body 400 that does not comprise the opening, so as to prevent any portion of the charged particle beam 302 from passing through the opening defined by the aperture body 400. The blanking electrode 330 may blank the beam so that beam does not pass through the opening of the aperture body 400. However, the combination of the blanking electrode 330 and the aperture body 400 may also be used to selectively blank the charged particle beam 302, i.e. to selectively prevent passage of at least part the charged particle beam 302 through the opening in the aperture body 400. That is, the combination of the blanking electrode 330 and the aperture body 400 may selectively control the proportion of the charged particle beam 302 that passes the opening.

The objective lens 340 is positioned down-beam of the aperture body 400. The objective lens 340 may focus or defocus the charged particle beam 302. As shown in Fig. 2, the objective lens 320 may be used to control the charged particle beam 302 so as to create a divergent beam, thereby increasing the spot size on the sample 208 and increasing the area of the surface on the sample 208 that is flooded with charged particles. However, in some situations, the objective lens 340 may be used to control the charged particle 302 so as to create a convergent beam, thereby focusing the charged particle beam 302 onto the sample 208. A field lens (not shown), for example positioned down-beam of the objective lens, may be used to set the strength of the electric field between the field lens and the sample 208. This electric field affects the charged particle as they travel towards the sample 208, thereby affecting the charging speed and the charging level (i.e. the maximum voltage of the sample 208 with respect to electrical ground after charged particle flooding) of the sample 208 during charged particle flooding.

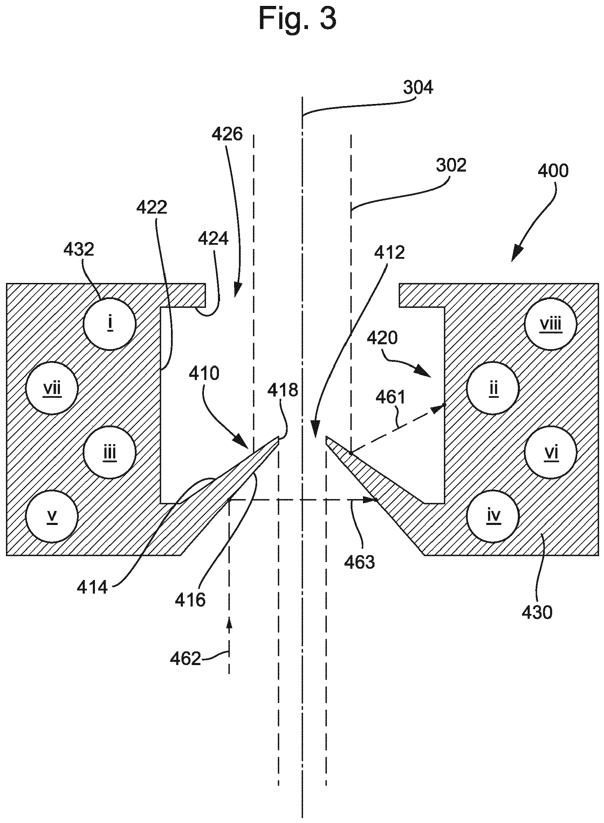

In an embodiment, there is provided the aperture body 400, for example the aperture body 400 depicted in Fig. 3. The aperture body 400 is for passing a portion, or only a portion and not all, of a charged particle beam 302. The aperture body 400 may thus be a beam-limiting aperture body 400, i.e. limit the lateral extent of the charged particle beam 302. The aperture body 400 may also be for selectively blanking the charged particle beam 302. The aperture body 400 may be used in the flood column 300. Alternatively, the aperture body 400 may be used in the charged particle inspection tool 200, or in any other apparatus that makes use of an aperture body for passing a portion or proportion of a charged particle beam.

The aperture body 400 comprises an aperture portion 410. The aperture portion 410 defines an opening 412, i.e. the opening 412 is provided in the aperture portion 410. The opening 412 is positioned around the axis 304. Adjacent to the opening 412, the aperture portion 410 comprises an up-beam facing surface 414 and a down-beam facing surface 416. The up-beam facing surface 414 is located on an up-beam side of the aperture portion 410. The down-beam facing surface 416 is located on a down-beam side of the aperture portion 416. The up-beam side may be opposite in the beam path to the down-beam side.

As shown in Fig. 3, the up-beam facing surface 414 is angled with respect to a plane that is perpendicular to the axis 304. The opening 412 in the up-beam facing surface 414 is up-beam of a more radially outward portion of the up-beam facing surface 414. The angle formed between the down-beam direction and the up-beam facing surface is an acute angle. Charged particles travelling along the beam path 302, for example in a down-beam direction onto the up-beam facing surface 414, that impinge or are incident on the up-beam facing surface 414 may be backscattered from the up-beam facing surface 414. The backscattered charged particles may be deflected radially outwardly (or away from the axis 304), in particular with a trajectory that is preferably radially away from the axis 304, as shown by the example backscattered beam path 461 in Fig. 3. Compared to a situation in which the up-beam facing surface 414 is perpendicular to the axis 304, the risk of such backscattered charged particles being deflected towards other components (e.g., with reference to the flood column 300 of Fig. 2, towards the blanking electrode 330, the condenser lens 320, the charged particle source 301, or other up-beam components of the flood column 300) is reduced. This may reduce the heat load of such up-beam components due to backscattered charged particles, and may also reduce the complexity of controlling such up-beam components by avoiding or reducing the need to account for the incidence of backscattered charged particles on the electronic behavior of such components. Deflecting the backscattered charged particles with a trajectory that is preferably radially away from the axis 304 may also reduce Coulomb interactions between the backscattered charged particles and the charged particle beam 302.

The down-beam facing surface 416 may also be angled with respect to the plane that is perpendicular to the axis 304. The opening 412 defined in the down-beam facing surface 416 is up-beam of a more radially outward portion of the down-beam facing surface 416. The angle formed between the down-beam direction and the down-beam facing surface is an acute angle. As such, charged particles travelling contrary to the direction of travel of a charged particle along the beam path 302 towards the down-beam facing surface, for example in the up-beam direction onto the down-beam facing surface 416, as shown by the example beam path 462, may be incident on the down-beam facing surface 416. A charged particle that is incident on the down-beam facing surface 416 may be backscattered from the down-beam facing surface 414. Such a backscattered charged particle may be deflected radially inwardly (or towards the axis 304), in particular with a trajectory that is preferably radially towards the axis 304, as shown by the example backscattered beam path 463 in Fig. 3. Charged particles may travel in the up-beam direction for example due to backscattering from the surface of the sample 208. Compared to a situation in which the down-beam facing surface 414 is perpendicular to the axis 304, the risk that charged particles backscattered from the down-beam facing surface 414 are deflected towards other components (e.g., with reference to the flood column 300 of Fig. 2, towards the objective lens 340, or other down-beam components of the flood column 300) is reduced. This may reduce the heat load of such down-beam components due to backscattered charged particles.

The up-beam facing surface and/or the down-beam facing surface may be angled so as to allow deflection of charged particles onto another part of the aperture body 400. For example, as shown in Fig. 3, backscattered charged particles may be deflected from the up-beam facing surface 414 onto a surface of chamber portion 420 of the aperture body 400. Backscattered charged particles may be deflected from the down-beam facing surface 416 onto another portion of the down-beam facing surface 416. The backscattered charged particles may then be absorbed by the other part of the aperture body 400. This may reduce the risk that charged particles that are backscattered by the aperture body 400 are absorbed by components other than the aperture body 400, reducing the heat load due to backscattered charged particles in such other components.

As shown in Fig. 3, the aperture portion 410 may be cylindrically symmetric, for example cylindrically symmetric about the beam path and/or about the axis 304. The aperture portion 410 may be rotationally symmetric about the beam path and/or about the axis 304. In particular, the up-beam facing surface 414 and/or the down-beam facing surface 416 and/or the opening 212 may be rotationally symmetric or cylindrically symmetric, for example rotationally symmetric or cylindrically symmetric about the beam path and/or about the axis 304. The opening 212 may be circular, for example. The up-beam facing surface 414 and/or the down-beam facing surface 416 may, for example, be shaped as a portion of a cone. For example, the up-beam facing surface 414 may be shaped as the lateral surface of a cone-frustum. Similarly, the down-beam facing surface 416 may be shaped as the lateral surface of a cone-frustum. The conical section of each cone associated with the respective cone-frusta may be substantially common. The common cone section may be the opening 412. The cone angle of the up-beam facing surface 414 may be larger than the cone angle of the down-beam facing surface 416. The cone angle of the up-beam facing surface 414 may, for example, be smaller than 170 degrees, or smaller than 135 degrees. The cone angle of the up-beam facing surface may be more than 90 degrees, in the range of 90 and 180 degrees, preferably in the range of 100 to 150 degrees. The cone angle of down-beam facing surface 416 may in the range of 90 and 180 degrees and preferably in the range of 105 to 155 degrees. The angular difference between the up-beam facing surface 414 and the down-beam facing surface may be in the range of 5 to 40 degrees, preferably a difference of 20 degrees. The cone angle may be chosen so as to preferentially deflect backscattered charged particles towards another part of the aperture body 400, for example towards the chamber portion 420.

Alternatively, the up-beam facing surface 414 and/or the down-beam facing surface 416 may diverge from a conical shape. For example, the up-beam facing surface 414 and/or the down-beam facing surface 416 may be shaped such that charged particles that are backscattered from a radially inward part of the up-beam facing surface 414 and/or the down-beam facing surface 416 are deflected more than charged particles that are backscattered from a radially outward part of the up-beam facing surface 414 and/or the down-beam facing surface 416, or vice versa. The up-beam facing surface 414 and/or the down-beam facing surface 416 may be of a convex shape or of a concave shape. Preferably the aperture portion is rotationally symmetric around the beam path/axis.

The up-beam facing surface 414 and the down-beam facing surface 416 may be surfaces of a plate of the aperture portion 410. In particular, the up-beam facing surface 414 and the down-beam facing surface 416 may, with respect to the direction of the beam path, be opposing surfaces of a plate of the aperture portion 410. The plate may be tapered towards the opening 412, as shown in Fig. 3. The up-beam and down beam facing surfaces 414, 416 may be angled so that the plate is thinnest at the opening 412. A radially inner part of the aperture portion 410 (i.e. the part that faces the opening 412) may thus be relatively dimensionally small, e.g. thin. Thus the preferably minimized dimension of the radially inner part of the aperture portion may reducing any effects of that part on the charged particle beam 302. The radially outer part of the aperture portion 410 may have relatively large dimension in the direction of the beam path. A thicker outer part of the aperture portion 410 may improve the structural integrity of the aperture portion 410, and may also provide more material to absorb and conduct heat generated by incident charged particles on the aperture portion 410.

The up-beam facing surface 414 and the down-beam facing surface 416 may meet adjacent to the opening 412, such that the distance between the up-beam facing surface 414 and the down-beam facing surface 416 at the opening 412 is substantially zero. Alternatively, an opening facing surface 418 may extend between the up-beam facing surface 414 and the down-beam facing surface 416 defining the opening 212. The opening facing surface 418 may interconnect the up-beam facing surface 414 and the down-beam facing surface 416. The opening facing surface 418 may be inwardly facing. The extent of the opening facing surface 418 in a direction parallel to the axis 304 may be small, e.g. its thickness is desirably minimized, so as to minimize any effect the opening facing surface 418 may have on the charged particle beam 302. A thin opening facing surface 418 may reduce the chances of a charged particle interacting with the opening facing surface 418 to backscatter, impacting beam performance. For example, the extent of the opening facing surface 418 in the direction parallel to the axis 304 may be less than 2mm, less then 1mm, less than 500µm, preferably less than 100µm, further preferably less than 50µm, further for optimising for the electron-optical performances less than 10µm.

The opening 412 may be substantially circular. The opening 412 may have a lateral extent (or diameter) in the range from 100µm to 10mm, preferably from 200µm to 5mm, further preferably from 500µm to 2mm. The minimum extent of the up-beam facing surface 414 and/or of the down-beam facing surface 416 in a direction perpendicular to the axis 304 may be greater than 1.5 times, for example greater than 2 or 3 times, the lateral extent of the opening. This may ensure that the charged particle beam 302, when deflected away from the opening (for example by the blanking electrode 330), can remain fully on the up-beam facing surface 414. The minimum extent of the up-beam facing surface 414 and/or of the down-beam facing surface 416 in a direction perpendicular to the axis 304 may be greater than 200µm, preferably greater than 500µm, further preferably greater than 1.5mm. The maximum extent of the up-beam facing surface 414 and/or the down-beam facing surface 416 in a direction perpendicular to the axis 304 may be less the 10mm, preferably less the 5mm

As shown in Fig. 3, the aperture body 400 may comprise a chamber portion 420. The chamber portion 420 may be positioned around the aperture portion 410, for example around the up-beam facing surface 414 of the aperture portion 410. The up-beam facing surface 414 may be angled so as to have an increased proportion of backscattering charged particles from the beam path be deflected onto a surface of the chamber portion 420. The chamber portion 420 may be configured such that charged particles in the beam path that impact the up-beam facing surface and are backscattered from the up-beam facing surface 414 may be deflected onto a surface of the chamber portion 420. This may reduce the risk that charged particles that are backscattered from the up-beam facing surface 414 are deflected towards components other than the aperture body 400.

The chamber portion 420 may comprise a tubular portion 422. The tubular portion 422 may extend in the up-beam direction from the aperture portion 410. The tubular portion 422 may be cylindrically symmetrical, for example cylindrically symmetrical about the axis 304. The tubular portion 422 may comprise a hollow cylinder. The chamber portion 420 may further comprise an up-beam plate 424. The up-beam plate 424 may extend radially inward from the tubular portion 422, preferably from an up-beam end of the tubular portion 422. The up-beam plate 422 may be cylindrically symmetrical, for example cylindrically symmetrical about the axis 304. The up-beam plate 422 may define an entrance opening 426. The entrance opening 426 is of larger diameter than the opening 412 of the aperture portion 410, such that a charged particle beam 302 may fully pass through the opening in the up-beam plate 424 and only partially pass through the opening 412 in the aperture portion 410. Further, the diameter of the entrance opening 426 may be (optimally) dimensioned so that backscattered electrons from the up-beam facing surface 414 have a reduced or minimized chance of passing in the up-beam direction through the entrance opening 426. Preferably the backscattered electrons traveling in the up-beam direction, which are not incident on the tubular portion 422 of the chamber portion 420, are incident on a surface of the up-beam plate 422. Thus the chamber portion 420 configured in this manner may effectively absorb charged particles that are backscattered from the up-beam facing surface 414 of the aperture portion 410.

The aperture body 400 may further comprise a thermal conditioning portion 430. The tubular portion 422 may comprise the thermal conditioning portion 430. The thermal conditioning portion 430 may be for thermal conditioning, for example for cooling, of the aperture body 400, in particular of the aperture portion 410 and/or of the chamber portion 420. Incidence of charged particles on a surface of the aperture body 400 may generate heat. The provision of thermal conditioning to the aperture body may beneficially address any heat load on the aperture body generated by the incident charged particles. Providing the thermal conditioning portion 430 as part of the aperture body 400 may lead to efficient thermal conditioning, e.g. cooling, of the aperture body 400. The heat load at the aperture body 400 may be higher than the heat load of other components in a system in which the aperture body 400 is included. In an arrangement, the aperture body 400 is the only element in the system on which the entire beam may be incident. Thus efficient thermal conditioning of the aperture body 400 may be particularly useful. Such thermal conditioning of improved efficiency may be especially useful in combination with the up-beam facing surface 414, which may be angled so as to allow backscattered charged particles to be directed towards other portions of the aperture body 400 and away from components other than the aperture body 400. In the aperture body 400 having the thermal conditioning portion, the need for thermal conditioning of components other than the aperture body 400 may be reduced.

The thermal conditioning portion 430 may comprise a thermal conditioning channel 432, for example a single thermal conditioning channel 432, as shown in Fig. 3. The thermal conditioning channel may be configured for circulation of a thermal conditioning fluid within it. The numerals i to viii in Fig. 3 schematically denote the order in which the thermal conditioning fluid may flow through the thermal conditioning channel 432. Each of the circular cross sections shown in Fig. 3 may be cross sections of the same thermal conditioning channel 432 at different positions along the length of the thermal conditioning channel 432 (which wraps around the aperture portion 410 multiple times). For example a cooling fluid, such as water, may be arranged to circulate around the aperture portion 410 and/or around the chamber portion 420. At least part of the thermal conditioning channel may be configured to circulate the thermal conditioning fluid multiple times around the beam axis, for example four (4) or more times, or eight (8) or more times, around the aperture portion 410 and/or around the chamber portion 420. A thermal conditioning channel 432 with multiple circuits around the axis, in the aperture body 400 may improve thermal conditioning of the aperture body 400.

The at least part of the thermal conditioning channel 432 may be shaped as a spiral and/or as a helix. As shown in Fig. 3, the at least part of the thermal conditioning channel may be shaped as two or more concentric helices. The thermal conditioning channel 432 may be shaped such that the thermal conditioning fluid is directed first around an inner helix of the two or more concentric helices and then around an outer helix of the two or more concentric helices. Alternatively, the thermal conditioning channel 432 may be shaped so as to branch into multiple parallel sub-channels (not shown). The thermal conditioning channel 432 may also be shaped in any other geometries that allow the thermal conditioning fluid to be passed through the aperture body 400.

The cross section of the thermal conditioning channel 432 may be circular, as shown in Fig. 3. Preferably, the cross section of the thermal conditioning channel 432 is shaped so as to increase or maximize the surface area of the thermal conditioning channel 432, thereby improving heat exchange between the aperture body 400 and the thermal conditioning fluid. For example, the cross section of the thermal conditioning channel 432 may be square or angular, allowing a larger proportion of the cross section of the aperture body 400 to be formed of the thermal conditioning channel 432 compared to a situation in which the cross section of the thermal conditioning channel 432 is circular (because square or angular cross sections can be packed more closely than circular cross sections). The cross section of the thermal conditioning channel 432 may vary along the length of the thermal conditioning channel (unlike shown in Fig. 3), thus allowing the thermal conditioning channel 432 with angular cross section to be shaped as two or more concentric helices while remaining relatively closely packed. The proportion of the total cross section of the thermal conditioning channel 432 to the cross section of the aperture body 400 in a plane comprising the axis 304 (so for example the sum of the cross sections i-viii in Fig. 3) may be greater than 50%, preferably greater than 60%, further preferably greater than 70%. The optimal range of the proportion of the aperture body which is comprised of the cross-sectional area of the cooling changes is preferably in the range of 70 to 80%. At the top of the range of proportion there is a risk that there is insufficient material of the aperture body to conduct heat generated from within the aperture body to the radial outward parts of the cooling channels. The proportions may be dependent on the cooling fluid for which the cooling channel is designed.

When the aperture body 400 is included in the flood column 300, the thermal conditioning channel may also provide the thermal conditioning fluid to the interface 350 between the flood column 300 and the primary column of the charged particle tool 40. In an arrangement a portion of the thermal conditioning channel is located within the interface 350. Thermal conditioning of this interface 350 may reduce the risk of a heat load in the flood column 300 affecting operation of the primary column. To further reduce this risk, the cooling channel may provide the cooling fluid to the interface 350 before circulating the thermal conditioning fluid around the aperture portion 410 and/or around the chamber portion 420. The portion of the thermal conditioning channel may be located upstream, in the flow of the thermal conditioning fluid, of the portion of the thermal conditioning channel in the aperture body 400.

The aperture body 400 may be a integrally formed, i.e. the aperture portion 410, the chamber portion 420 and/or the thermal conditioning portion 430 may be integrally formed with each other, optionally in a monolithic element. The aperture portion 410, the chamber portion 420 and/or the thermal conditioning portion 430 may be formed from a single material. This may improve heat conduction within the aperture body 400, as well as reduce the risk of thermal conditioning fluid leaking from the thermal conditioning portion 430. This may be especially useful when the aperture body 400 is used in a vacuum or low-pressure environment, such as within the flood column 300. For this purpose, the aperture body 400 may be fabricated using 3d printing techniques. This may also allow elements and/or features of the aperture body 400, for example the thermal conditioning portion 430 of the aperture body, to be formed in relatively complex shapes.

The aperture body 400 may be made from a conductive material. For example, the aperture body 400 may be made from a metal, such as titanium or stainless steel.

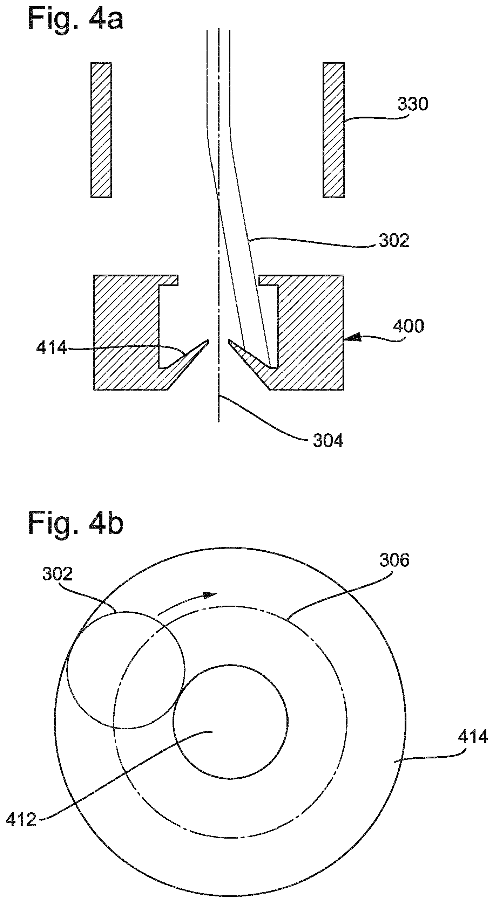

In an embodiment, there is provided the combination of the blanking electrode 330 and the aperture body 400, as schematically depicted in Fig. 4a. The blanking electrode 330 is positioned in the up-beam direction relative to the aperture body 400, i.e. the blanking electrode 330 is positioned up-beam of the aperture body 400. The blanking electrode 330 may selectively deflect the charged particle beam 302 onto the up-beam facing surface 414 of the aperture body 400 so as to prevent any portion of the charged particle beam 302 from passing through the opening 412. This may prevent the charged particle beam 302 from reaching a down-beam sample 208, effectively preventing exposure of such a down-beam sample 208 to the charged particle beam 302 without requiring the charged particle beam 302 to be turned off (e.g. by turning off the charged particle source 301).

The blanking electrode 330 may continually deflect the charged particle beam 302 so that the point of incidence of the charged particle beam 302 with the aperture body 400, in particular with the up-beam facing surface 414 of the aperture portion 410, continually moves. The blanking electrode 330 may deflect the charged particle beam 302 so as to continually move the charged particle beam 302. This reduces the heat load, caused by exposure of the aperture body 400 to the charged particle beam 302 during blanking, on any one area of the aperture body 400. The point of incidence of the charged particle beam 302 with the aperture body 400 may move over the up-beam facing surface 414, desirably around the opening 412 defined by the aperture portion 410 of the aperture body 400. Preferably, as schematically depicted in Fig. 4b, the point of incidence of the charged particle beam 302 with the aperture body 400 moves around the opening 412 in a path that is preferably annular such as a circular path. Fig. 4b shows, in plan, the path 306 of the centroid of the charged particle beam 302 on the up-beam facing surface 414 of the aperture portion 410 of the aperture body 400. During blanking, the lateral extent of the charged particle beam 402 may be controlled, for example by the condenser lens 320 or other lens element, so as to match or be substantially equal to the lateral extent of the up-beam facing surface 414 between the opening 412 and a radially outward end of the up-beam facing surface 414. In other words, the lateral extent of the charged particle beam 302 during blanking may be controlled so as to be maximized while remaining fully on the up-beam facing surface 414. This may further reduce the heat load, as the charged particle beam 302 may be spread over a larger area.

In an embodiment, there is provided the aperture body 400 for passing a portion of the charged particle beam 302 along the beam path. The aperture body 400 comprises the aperture portion 410 having the up-beam facing surface 414 and the down-beam facing surface 416 and the opening 412 around the beam path defined in and common to the up-beam and down-beam facing surfaces 414, 416. The up-beam and down-beam facing surfaces 414, 416 are respectively angled so that a dimension of the aperture portion 410 between the up-beam and down-beam facing surfaces 414, 416 is smallest in the direction of the beam path at the opening 412.

In an embodiment, there is provided the flood column 300. The flood column comprises the aperture body 400 optionally in combination with the blanking electrode 330.

In an embodiment, there is provided the flood column 300. The flood column comprises the aperture body 400. The aperture body 400 comprises the aperture portion 410, which defines the opening 412 for the passage of at least a portion of the charged particle beam 302. The flood column 300 further comprises the interface 350 for physically or mechanically connecting the flood column 300 to the primary column of the charged particle tool 40. The thermal conditioning channel is integrated in the aperture body 400, and may provide a thermal conditioning fluid to the interface 350 before circulating the thermal conditioning fluid around the aperture portion 410. This improves thermal conditioning of the interface 350, reducing the risk that heat loads in the flood column 300 affect operation of a primary column (which is physically connected to the flood column 300).

In an embodiment, there is provided the charged particle tool 40. The charged particle tool 40 comprises the flood column 300. The charged particle tool 40 further comprises the charged particle inspection tool 200. The flood column 300 and the charged particle inspection tool 200 may be separate elements, e.g. provided in separate columns. The charged particle inspection tool 200 comprises a primary column for directing a primary charged particle beam onto the surface of the sample. The charged particle inspection tool 200 further comprises a detection column for detecting charged particles emitted from the surface of the sample due to the primary charged particle beam.

In an embodiment, there is provided the aperture body 400 for passing a portion of a charged particle beam 302 along a beam path. The aperture body 400 comprises an aperture portion 410 having the up-beam facing surface 414 and the down-beam facing surface 416, the opening 412 around the beam path defined in and common to the up-beam and down-beam facing surfaces 414, 416. The up-beam facing surface 414 is angled a) with respect to the beam path, so that the up-beam facing surface 414) allows charged particles travelling along the beam path to be deflected radially outwardly; or b) so that the opening in the up-beam facing surface 414 is up-beam of a more radially outward portion of the up-beam facing surface 414.

The down-beam facing surface 416 may be angled a) with respect to the beam path, so that the down-beam facing surface 416 allows charged particles travelling contrary to the beam path to be deflected radially inwardly; or b) so that the opening 412 in the down-beam facing surface 416 is up-beam of a more radially outward portion of the down-beam facing surface.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims. Reference to inspection throughout this specification is intended also to refer to measurement, i.e. metrological applications.

The descriptions above are intended to be illustrative, not limiting. Thus, it will be apparent to one skilled in the art that modifications may be made as described without departing from the scope of the claims set out below.

Embodiments are provided by the following clauses:
Clause 1: An aperture body for passing a portion of a charged particle beam propagating along a beam path comprising an axis, the aperture body comprising: an aperture portion defining an opening around the axis; wherein the aperture portion comprises, adjacent to the opening, an up-beam facing surface, and a down-beam facing surface; wherein the up-beam facing surface is angled with respect to a plane that is perpendicular to the axis, so that the opening in the up-beam facing surface is up-beam of a more radially outward portion of the up-beam facing surface.
Clause 2: The aperture body of clause 1, wherein the down-beam facing surface is angled with respect to the plane that is perpendicular to the axis, so that the opening in the down-beam facing surface is up-beam of a more radially outward portion of the down-beam facing surface.
Clause 3: The aperture body of clause 1 or 2, wherein the up-beam facing surface and/or the down-beam facing surface is angled so as to allow deflection of charged particles onto another part of the aperture body.
Clause 4: The aperture body of any one of the preceding clauses, wherein the aperture portion is cylindrically symmetric.
Clause 5: The aperture body of any one of the preceding clauses, wherein the up-beam facing surface and/or the down-beam facing surface is shaped as the lateral surface of a cone frustum.
Clause 6: The aperture body of any one of the preceding clauses, wherein the up-beam facing surface and the down-beam facing surface are opposing surfaces of a plate of the aperture portion.
Clause 7: The aperture body of clause 6, wherein the plate is tapered towards the opening.
Clause 8: The aperture body of any one of the preceding clauses, further comprising a chamber portion around the up-beam facing surface of the aperture portion, wherein the up-beam facing surface is angled so as to allow deflection of the charged particles in the beam path onto a surface of the chamber portion.
Clause 9: The aperture body of clause 8, wherein the chamber portion comprises: a tubular portion extending up-beam from the aperture portion; and an up-beam plate extending radially inward from an up-beam end of the tubular portion, the up-beam plate defining an opening of larger diameter than the opening of the aperture portion.
Clause 10: The aperture body of any one of the preceding clauses, further comprising a thermal conditioning portion for thermal conditioning of the aperture body.
Clause 11: The aperture body of clause 10, wherein the thermal conditioning portion comprises a thermal conditioning channel, wherein at least part of the thermal conditioning channel is configured to circulate a thermal conditioning fluid around the aperture portion.
Clause 12: The aperture body of clause 11, wherein the at least part of the thermal conditioning channel is configured to circulate the thermal conditioning fluid multiple times around the aperture portion.
Clause 13: The aperture body of clause 11 or 12, wherein the at least part of the thermal conditioning channel is shaped as a spiral or a helix.
Clause 14: The aperture body of clause 13, wherein the at least part of the thermal conditioning channel is shaped as two or more concentric helices.
Clause 15: The aperture body of any one of clauses 11 to 14, wherein the thermal conditioning channel is configured to provide the thermal conditioning fluid to an interface between a flood column and a primary column of a charged particle tool.
Clause 16: The aperture body of clause 15, wherein the cooling channel is configured to provide the cooling fluid to the interface before circulating the thermal conditioning fluid around the aperture portion.
Clause 17: The aperture body of any one of the preceding clauses, wherein the aperture body is a integrally formed.
Clause 18: A combination of a blanking electrode and the aperture body of any one of the preceding clauses, wherein the blanking electrode is positioned in the up-beam direction relative to the aperture body, and wherein the blanking electrode is configured to selectively deflect the charged particle beam onto the up-beam facing surface of the aperture body so as to prevent any portion of the charged particle beam from passing through the opening.
Clause 19: The combination of clause 18, wherein the blanking electrode is configured to continually deflect the charged particle beam so that the point of incidence of the charged particle beam with the aperture body continually moves.
Clause 20: The combination of clause 18 or 19, wherein the blanking electrode is configured to continually deflect the charged particle beam so that the point of incidence of the charged particle beam with the aperture body moves around the opening, preferably in a circle.
Clause 21: A flood column for charged particle flooding of a sample, the flood column comprising the aperture body of any one of clauses 1 to 17 or the combination of any one of clauses 18 to 20.
Clause 22: A flood column for charged particle flooding of a sample, the flood column comprising: an aperture body comprising an aperture portion defining an opening for the passage of at least a portion of the charged particle beam; an interface for physically connecting the flood column to a primary column of a charged particle tool; and a thermal conditioning channel that is integrated in the aperture body, wherein the thermal conditioning channel is configured to provide a thermal conditioning fluid to the interface before circulating the thermal conditioning fluid around the aperture portion.
Clause 23: A charged particle tool comprising: the flood column of clause 21 or 22 for charged particle flooding of the sample; and a charged particle inspection tool comprising: a primary column for directing a primary charged particle beam onto the surface of the sample; and a detection column for detecting charged particles emitted from the surface of the sample due to the primary charged particle beam.
Clause 24: An aperture body for passing a portion of a charged particle beam along a beam path, the aperture body comprising: an aperture portion having an up-beam facing surface and a down-beam facing surface, an opening around the beam path defined in and common to the up-beam and down-beam facing surfaces, wherein the up-beam facing surface is angled: with respect to the beam path, so that the up-beam facing surface allows charged particles travelling along the beam path to be deflected radially outwardly; or so that the opening in the up-beam facing surface is up-beam of a more radially outward portion of the up-beam facing surface.
Clause 25: The aperture body of clause 24, wherein the down-beam facing surface is angled: with respect to the beam path, so that the down-beam facing surface allows charged particles travelling contrary to the beam path to be deflected radially inwardly; or so that the opening in the down-beam facing surface is up-beam of a more radially outward portion of the down-beam facing surface.
Clause 26: An aperture body for passing a portion of a charged particle beam along a beam path, the aperture body comprising: an aperture portion having an up-beam facing surface and a down-beam facing surface, an opening around the beam path defined in and common to the up-beam and down-beam facing surfaces, wherein the up-beam and down-beam facing surfaces are respectively angled so that a dimension of the aperture portion between the up-beam and down-beam facing surfaces is smallest in the direction of the beam path at the opening.

## Claims

1. An aperture body for passing a portion of a charged particle beam propagating along a beam path comprising an axis, the aperture body comprising:
an aperture portion defining an opening around the axis;
wherein the aperture portion comprises, adjacent to the opening, an up-beam facing surface, and a down-beam facing surface;
wherein the up-beam facing surface is angled with respect to a plane that is perpendicular to the axis, so that the opening in the up-beam facing surface is up-beam of a more radially outward portion of the up-beam facing surface.

2. The aperture body of claim 1, wherein the down-beam facing surface is angled with respect to the plane that is perpendicular to the axis, so that the opening in the down-beam facing surface is up-beam of a more radially outward portion of the down-beam facing surface.

3. The aperture body of claim 1 or 2, wherein the up-beam facing surface and/or the down-beam facing surface is angled so as to allow deflection of charged particles onto another part of the aperture body.

4. The aperture body of any one of the preceding claims, wherein the aperture portion is cylindrically symmetric.

5. The aperture body of any one of the preceding claims, wherein the up-beam facing surface and/or the down-beam facing surface is shaped as the lateral surface of a cone frustum.

6. The aperture body of any one of the preceding claims, wherein the up-beam facing surface and the down-beam facing surface are opposing surfaces of a plate of the aperture portion.

7. The aperture body of claim 6, wherein the plate is tapered towards the opening.

8. The aperture body of any one of the preceding claims, further comprising a chamber portion around the up-beam facing surface of the aperture portion, wherein the up-beam facing surface is angled so as to allow deflection of the charged particles in the beam path onto a surface of the chamber portion.

9. The aperture body of any one of the preceding claims, further comprising a thermal conditioning portion for thermal conditioning of the aperture body.

10. The aperture body of claim 9, wherein the thermal conditioning portion comprises a thermal conditioning channel, wherein at least part of the thermal conditioning channel is configured to circulate a thermal conditioning fluid around the aperture portion.

11. The aperture body of claim 10, wherein the at least part of the thermal conditioning channel is shaped as a spiral or a helix.

12. The aperture body of claim 10 to 11, wherein the thermal conditioning channel is configured to provide the thermal conditioning fluid to an interface between a flood column and a primary column of a charged particle tool.

13. A combination of a blanking electrode and the aperture body of any one of the preceding claims,
wherein the blanking electrode is positioned in the up-beam direction relative to the aperture body, and
wherein the blanking electrode is configured to selectively deflect the charged particle beam onto the up-beam facing surface of the aperture body so as to prevent any portion of the charged particle beam from passing through the opening.

14. A flood column for charged particle flooding of a sample, the flood column comprising the aperture body of any one of claims 1 to 12 or the combination of claim 13.

15. A charged particle tool comprising:
the flood column of claim 14 for charged particle flooding of the sample; and
a charged particle inspection tool comprising:
a primary column for directing a primary charged particle beam onto the surface of the sample; and
a detection column for detecting charged particles emitted from the surface of the sample due to the primary charged particle beam.
